(19) Europäisches Patentamt / European Patent Office / Office européen des brevets

(11) **EP 1 926 208 A1**

(12) **DEMANDE DE BREVET EUROPEEN**

(43) Date de publication:
**28.05.2008 Bulletin 2008/22**

(51) Int Cl.:
**H03D 7/14** *(2006.01)*

(21) Numéro de dépôt: **07121173.4**

(22) Date de dépôt: **21.11.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK RS**

(30) Priorité: **24.11.2006 FR 0610288**

(71) Demandeur: **STMICROELECTRONICS SA 92120 Montrouge (FR)**

(72) Inventeurs:
• **Butaye, Benoît**
  **38400 Saint Martin d'Heres (FR)**
• **Camus, Manuel**
  **38600 Fontaine (FR)**

(74) Mandataire: **Cabinet Plasseraud 52, rue de la Victoire F-75440 Paris Cedex 09 (FR)**

(54) **Mixeur et procédé de traitement de signaux, système sur puce comprenant un tel mixeur**

(57) Mixeur radiofréquence (100) adapté pour multiplier un premier signal radiofréquence (LOI) par un second signal radiofréquence (S'), caractérisé en ce que le premier signal radiofréquence est :
- soit un signal différentiel, correspondant à la différence entre une première composante de signal (LOIP) et une seconde composante de signal (LOIM) correspondant chacune à un signal respectif sensiblement carré et de rapport cyclique (a) inférieur à 0,25;
- soit un signal simple qui est un signal non différentiel sensiblement carré dont le rapport cyclique est inférieur à 0,25.

FIG. 4

**Description**

La présente invention concerne le traitement de signaux radiofréquences (RF) et trouve tout particulièrement des applications dans les circuits intégrés de type récepteurs de signaux RF qui comportent un multiplieur, encore appelé mélangeur ou mixeur (en anglais « Mixer »).

On trouve de tels circuits intégrés dispositifs dans des téléphones mobiles par exemple.

Un mixeur est un circuit adapté pour multiplier un signal correspondant à un signal RF reçu, de fréquence $F_{RF}$ et un signal d'oscillation de fréquence $F_{LO}$, généré par un oscillateur local du récepteur, en vue d'extraire une composante du signal résultant située à $a \times F_{RF} + b \times F_{LO}$ où a et b sont des entiers non nuls. Par exemple, la composante extraite correspond à (a ; b) = (1 ;-1)ou(-1 ; 1).

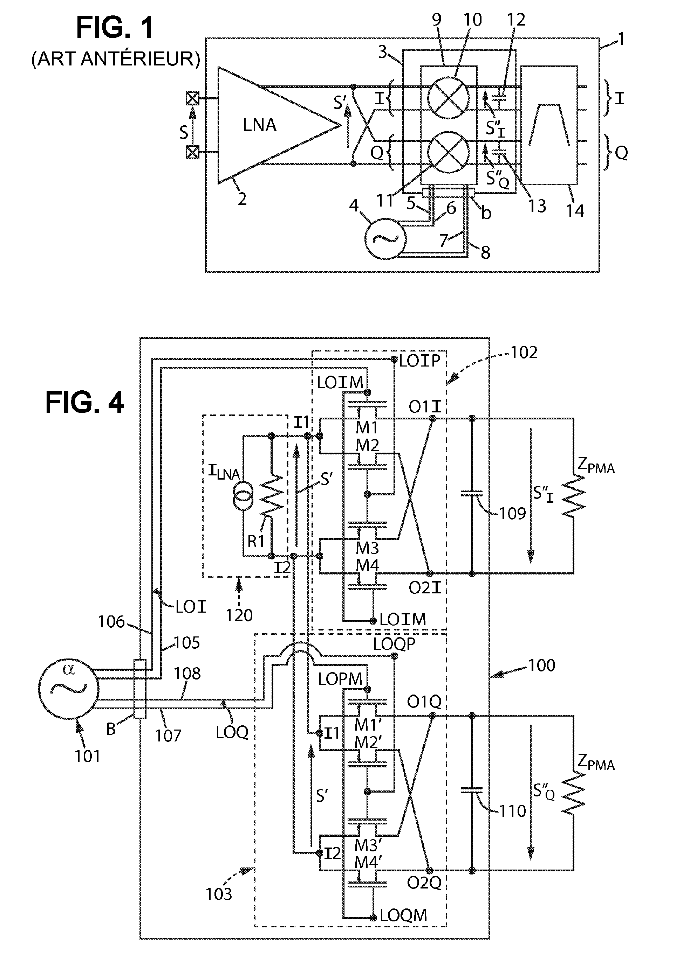

La figure 1 montre un récepteur radiofréquence standard 1 dans un système sur puce, qui comporte un amplificateur à faible bruit 2 (en anglais « Low Noise Amplifier » ou LNA), un mixeur 3, un générateur 4 de signaux d'oscillation et un amplificateur post mixeur (en anglais « Post Mixer Amplifier » ou PMA) avec un filtre 14.

Le mixeur 3 est un mixeur passif, c'est-à-dire qu'il fonctionne sans courant de polarisation.

L'amplificateur à faible bruit 2 est adapté pour recevoir un signal radiofréquence S et délivrer un signal S' résultant d'une première amplification du signal S par le récepteur, tout en dégradant peu le ratio signal sur bruit.

Dans le cas considéré en figure 1, ce signal S' est ensuite traité en parallèle par deux voies de traitement : une voie let une voie Q.

Le mixeur 3 comprend une borne d'entrée b adaptée pour recevoir en fonctionnement les signaux délivrés par le générateur 4, un bloc de multiplication 9 qui comporte un module de mélange 10, 11 pour chacune des voies I et Q. Le mixeur 3 comporte en outre, deux condensateurs 12, 13 de même capacité C dont l'un est disposé en parallèle de la sortie du module de mélange 10, et l'autre est disposé en parallèle de la sortie du module de mélange 11. Chaque condensateur tient lieu de filtre passe-bas.

Le générateur 4 de signaux d'oscillation est adapté pour fournir au module de mélange 10 du mixeur 3, via la borne d'entrée b, sur les canaux 5, 6, un signal d'oscillation différentiel TI de fréquence $F_{LO}$ et pour fournir au module de mélange 11, via la borne b et sur les canaux 7, 8, un signal d'oscillation différentiel TQ de Séquence $F_{LO}$,

Le signal différentiel TI est égal à la différence TIP - TIM, dans lequel TIM et TIP sont des signaux sensiblement carrés de rapport cyclique $\alpha$ =0,5, en opposition de phase, de fréquence $F_{LO}$, délivrés par le générateur 4 sur la voie 5, respectivement 6. Le rapport cyclique

$\alpha$ désigne le ratio entre le temps ($\tau$) à l'état haut dans une période (T) et la période (T), soit $\alpha = \dfrac{\tau}{T}$.

Le signal différentiel TQ est égal à la différence TQP - TIM, dans lequel TQM et TQP sont des signaux sensiblement carrés de rapport cyclique $\alpha$ =0,5, en opposition de phase, de fréquence $F_{LO}$, délivrés par le générateur 4 sur la voie 5, respectivement 6.

Les signaux d'oscillation TI et TQ des voies respectives I et Q sont généralement déphasés de 90°.

Dans le cas considéré, le mixeur 3 est un mixeur passif globalement tension-tension (dépendant du ratio entre impédance de sortie et impédance d'entrée), c'est-à-dire qu'il est caractérisé par un transfert de la tension d'entrée vers une tension de sortie.

La tension du signal S' est délivrée aux entrées de chaque module de mélange 10, 11.

Cette tension est mélangée par le module de mélange 10 avec la tension du signal TI (c'est-à-dire que la tension du signal S'est multipliée par la tension du signal TI) et elle est mélangée par le module de mélange 11 avec la tension du signal TQ (c'est-à-dire que la tension du signal S'est multipliée par la tension du signal TQ).

Le module de mélange 10 délivre un signal $S_I^{''}$ dont la tension est égale au mélange des tensions des signaux S'et TI.

Le module de mélange 11 délivre un signal $S_Q^{''}$ dont la tension est égale au mélange des tensions des signaux S' et TQ.

Les condensateurs 12 et 13 éliminent les fréquences hautes des signaux $S_I^{''}$ et $S_Q^{''}$, c'est-à-dire les signaux de fréquence supérieure à la fréquence -/+ ($F_{RF}$ - $F_{LO}$), notamment les composantes situées à la fréquence $F_{RF}$ + $F_{LO}$, et fournissent à l'entrée de l'amplificateur post mixeur avec filtre 14 les composantes des signaux $S_I^{''}$ et $S_Q^{''}$ à la fréquence -/+$F_{IF}$ = -/+ ($F_{RF}$ - $F_{LO}$). L'amplificateur post mixeur avec filtre 14 extrait, sur chaque voie I et Q, la composante visée pour les traitements ultérieurs (non représentés) dans le récepteur 1. Par exemple, la composante à la fréquence (+$F_{IF}$) est extraite et la composante à la fréquence opposée est éliminée. Dans un autre exemple, la fréquence (-$F_{IF}$) est extraite et la composante à la fréquence opposée est éliminée. La valeur de $F_{IF}$ est selon les cas positive ou négative.

Un tel traitement permet de réaliser un mixeur 3 avec réjection d'image puisqu'il permet de différencier dans la chaîne de traitement le signal S à la fréquence $F_{RF}$=$F_{LO}$+ $F_{IF}$ du signal image de fréquence $F_{LO}$ - $F_{IF}$.

Un tel mixeur a un gain en tension qui est égal

$$\text{à } \frac{2}{\pi} = -3,92 \text{ dB}.$$

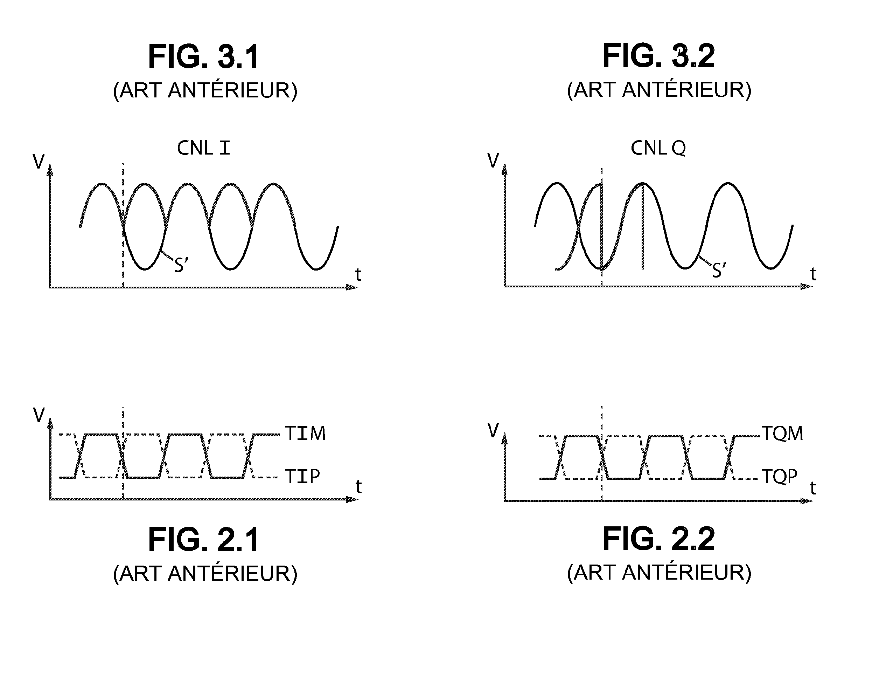

Pour illustration, dans un mode de réalisation, le signal de tension S' est un signal de type $A\cos(F_{RF}t)$ tel que représenté en trait fin sur les figures 3.1 et 3.2. Les signaux de tension TIM et TIP (voie I) de fréquence $F_{LO}$ sont représentés sur la figure 2.1. Les signaux de tension TQM et TQP (voie Q) de fréquence $F_{LO}$ sont représentés sur la figure 2.2.

Les signaux sur la voie I en sortie du mixeur 3 sont représentés en trait gras sur la figure 3.1 et les signaux de la voie Q en sortie du mixeur 3 sont représentés en trait gras sur la figure 3.2, dans un cas particulier où la capacité des condensateurs 12 et 13 est nulle (C = 0 F).

Le gain du mixeur 3 correspond à la moyenne du signal $\overset{''}{S}_{I,Q}$ redressé divisée par l'amplitude du signal d'entrée.

Il existe un besoin de disposer d'un mixeur présentant un gain amélioré par rapport au gain de -3,92 dB.

A cet effet, suivant un premier aspect, la présente invention vise à proposer un mixeur présentant un gain amélioré.

Un mixeur radiofréquence selon le premier aspect de l'invention comporte :

- une borne sur laquelle, en fonctionnement, un premier signal radiofréquence est disponible ;
- une entrée pour recevoir un second signal radiofréquence
- des moyens de multiplication adaptés pour multiplier le premier signal radiofréquence au second signal radiofréquence.

Un mixeur selon l'invention est caractérisé en ce que le premier signal radiofréquence est :

- soit un signal différentiel, correspondant à la différence entre une première composante de signal et une seconde composante de signal correspondant chacune à un signal respectif sensiblement carré et de rapport cyclique inférieur à 0,25 ;
- soit un signal simple qui est un signal non différentiel sensiblement carré dont le rapport cyclique est inférieur à 0,25.

Un tel mixeur permet d'obtenir un gain en sortie meilleur que le gain présenté par les mixeurs dans l'art antérieur.

Dans un mode de réalisation, le mixeur comprend une sortie pour délivrer une tension indiquant le résultat de la multiplication du premier signal radiofréquence et du second signal radiofréquence, et comprenant un condensateur en parallèle sur ladite sortie.

Cette disposition permet soit de diminuer la fréquence de coupure du filtre passe-bas correspondant au condensateur, soit à fréquence de coupure égale, de diminuer la taille du condensateur nécessaire.

Dans un mode de réalisation, le premier signal radiofréquence a une première fréquence et le second signal radiofréquence a une seconde fréquence, et la valeur absolue du quotient de la seconde fréquence par la première fréquence est comprise entre 0,5 et 2 (0,5 et 2 non inclus).

Dans un mode de réalisation, le premier signal est un signal différentiel et les moyens de multiplication comportent deux bornes d'entrée différentielles et deux bornes de sortie différentielles ; et :

- la première borne d'entrée est couplée aux sources communes d'un premier et deuxième transistor, la seconde borne d'entrée est couplée aux sources communes d'un troisième et quatrième transistor ;
- les grilles communes des premier et quatrième transistors reçoivent la première composante du premier signal et les grilles communes des deuxième et troisième transistors reçoivent la seconde composante du premier signal;
- la première borne de sortie est couplée aux drains communs des premier et troisième transistors, la seconde borne de sortie est couplée aux drains communs des deuxième et quatrième transistors.

Suivant un second aspect, l'invention propose un système sur puce comprenant un mixeur suivant le premier aspect de l'invention.

Suivant un troisième aspect, l'invention propose un procédé de traitement de signaux dans un mixeur adapté pour multiplier un premier signal radiofréquence à un second signal radiofréquence.

Le procédé selon l'invention est caractérisé en ce que le premier signal radiofréquence est :

- soit un signal différentiel, correspondant à la différence entre une première composante de signal et une seconde composante de signal correspondant chacune à un signal respectif sensiblement carré et de rapport cyclique inférieur à 0,25 ;
- soit un signal simple qui est un signal non différentiel sensiblement carré dont le rapport cyclique est inférieur à 0,25.

D'autres caractéristiques et avantages de l'invention apparaîtront encore à la lecture de la description qui va suivre. Celle-ci est purement illustrative et doit être lue en regard des dessins annexés sur lesquels:

- la figure 4 représente un mixeur dans un mode de réalisation de l'invention;
- la figure 5.1 représente l'évolution dans une fenêtre temporelle d'un signal d'oscillation différentiel sur la voie I dans le mixeur de la figure 4 ;
- la figure 5.2 représente l'évolution dans une fenêtre temporelle d'un signal d'oscillation différentiel sur la voie Q dans le mixeur de la figure 4 ;

- la figure 6.1 représente l'évolution dans une fenêtre temporelle des signaux en entrée et en sortie du mixeur de la figure 4 sur les voies I et Q pour 2 valeurs de capacité C1, dans le cas d'un rapport de cycle égal à 1/10 ;
- la figure 6.2 représente l'évolution dans une fenêtre temporelle des signaux en entrée et en sortie du mixeur de la figure 4 sur les voies I et Q pour 2 valeurs de capacité C1, dans le cas d'un rapport de cycle égal à 1/4 ;
- la figure 7 représente le gain d'un mixeur dans un mode de réalisation de l'invention en fonction du rapport de cycle ;
- la figure 8 représente schématiquement un générateur de signal d'oscillation de rapport de cycle égal à 0,25 ;
- la figure 9 représente schématiquement un générateur de signal d'oscillation de rapport de cycle strictement inférieur à 0,25.

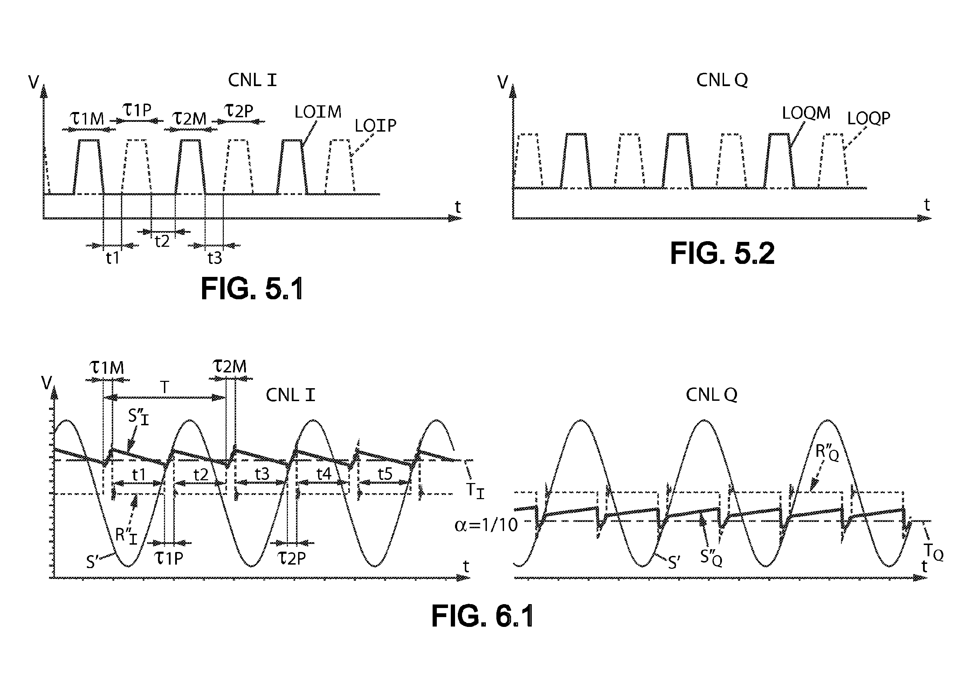

Dans un mode de réalisation de l'invention, on remplace dans un récepteur radiofréquence d'un système sur puce du type représenté en figure 1 (par exemple un système sur puce dans un téléphone mobile), le mixeur 3 et le générateur 4 par respectivement le mixeur 100 et le générateur 101 représentés en figure 4 et les condensateurs 12, 13 par les condensateurs 109, 110.

Le mixeur 100 comprend une borne B adaptée pour s'interfacer avec le générateur de signaux 101 et recevoir les signaux d'oscillation délivrés par ce dernier, un module de mélange 102 pour la voie I, un module de mélange 103 pour la voie Q. Le mixeur 100 comprend en outre en parallèle de la sortie du module de mélange 102 un condensateur 109, et en parallèle de la sortie du module de mélange 103 un condensateur 110.

Les condensateurs 109 et 110 ont tous deux une capacité de valeur C1.

Le générateur 101 de signaux d'oscillation est adapté pour fournir, via la borne d'entrée B du mixeur 100, au module de mélange 102, un signal d'oscillation différentiel LOI de fréquence $F_{LO}$ sur les canaux 105, 106 et pour fournir au module de mélange 103, sur les canaux 107, 108, un signal d'oscillation différentiel LOQ de fréquence $F_{LO}$.

Le signal différentiel LOI est égal à la différence LOIP - LOIM, où LOIM et LOIP sont des signaux sensiblement carrés de fréquence $F_{LO}$, délivrés par le générateur 101 sur la voie 105, respectivement 106.

La tension du signal LOIM en fonction du temps apparaît sur la figure 5.1 en trait plein, tandis que la tension du signal LOIP apparaît sur la figure 5.1 en trait pointillé.

Le signal différentiel TQ est égal à la différence LOQP - LOQM, où LOQM et LOQP sont des signaux sensiblement carrés en opposition de phase, de fréquence $F_{LO}$, délivrés par le générateur 101 sur la voie 107, respectivement 108.

La tension du signal LOQM en fonction du temps apparaît sur la figure 5.2 en trait plein, tandis que la tension du signal LOQP apparaît sur la figure 5.1 en trait pointillé.

Ainsi chaque signal d'oscillation LOIP, LOIM, LOQP et LOQM est un signal sensiblement carré, de fréquence $F_{LO}$, comportant une durée $\tau$ à l'état haut et une durée T-$\tau$ à l'état bas (T étant la période de ces signaux égale à $1/F_{LO}$), ce qui correspond à un rapport de cycle $\alpha = \dfrac{\tau}{T}$.

Selon l'invention, le rapport de cycle de chacun de ces signaux d'oscillation est strictement inférieur à 0,5.

Dans un mode de réalisation, les signaux d'oscillations LOIM et LOIP sont déphasés entre eux de 180°. De même, les signaux d'oscillations LOQM et LOQP sont déphasés entre eux de 180°.

Les signaux d'oscillation LOI et LOQ des voies respectives I et Q sont en outre déphasés entre eux de 90°.

Dans le mode de réalisation considéré, le module de mélange 102 de la voie I comporte deux bornes d'entrée différentielles I1 et I2 entre lesquelles la tension S' issue du LNA 2 est appliquée, et deux bornes de sortie différentielles OI1 et OI2 entre lesquelles la tension de sortie $S_I''$ du module est délivrée, cette tension de sortie indiquant le résultat du mélange (c'est-à-dire de la multiplication) entre le Signal S' et le signal LOI.

Le module de mélange 102 de la voie I comporte en outre 4 transistors CMOS M1, M2, M3 et M4 utilisés comme interrupteurs.

En référence à la figure 4, en parallèle de la sortie du module de mélange 102 du mixeur 100 est représentée une impédance $Z_{PMA}$ qui correspond à l'impédance présentée par l'amplificateur PMA 14 de la figure 1, correspondant à une source de tension intercalée entre deux résistances, permettant de fixer la polarisation des transistors M1, M2, M3 et M4.

Il est également possible de fixer la polarisation des transistors M1, M2, M3 et M4 à l'aide d'une impédance similaire à l'impédance $Z_{PMA}$ et disposée en amont du mixeur, côté Amplificateur à faible bruit.

La borne d'entée I1 est couplée aux sources communes des transistors M1 et M2, la borne d'entrée I2 est couplée aux sources communes des transistors M3 et M4. Les grilles communes des transistors M1 et M4 sont couplées à la voie 105 adaptée pour délivrer la tension du signal d'oscillation LOIM, tandis que les grilles des transistors M2 et M3 sont couplées à la voie 106 délivrant la tension du signal d'oscillation LOIP.

La borne de sortie O1I est couplée aux drains communs des transistors M1 et M3. La borne de sortie 021 est couplée aux drains communs des transistors M2 et M4.

Le module de mélange 103 de la voie Q comporte lui aussi les bornes d'entrée différentielles I1 et I2 entre lesquelles la tension S'issue du LNA 2 est appliquée. Il comporte en outre deux bornes de sortie différentielles OQ1 et OQ2 entre lesquelles la tension de sortie $\overset{''}{S_Q}$ du module est délivrée, cette tension de sortie indiquant le résultat du mélange entre le signal S' et le signal LOQ.

Le module de mélange 103 de la voie Q comporte en outre 4 transistors CMOS M1', M2', M3' et M4' montés similairement aux transistors respectifs M1, M2, M3 et M4 du module de mélange 102.

Est représentée en outre sur la figure 4, une impédance $Z_{PMA}$ en parallèle de la sortie du module de mélange 103 correspondant à l'impédance présentée par l'amplificateur PMA 14 de la figure 1, correspondant à une source de tension intercalée entre deux résistances, permettant de fixer la polarisation des transistors M1 M2', M3' et M4'.

Le fonctionnement du module de mélange 102 pendant une période T est décrit ci-dessous. Le fonctionnement du module 103 de mélange est similaire.

D'après leur montage représenté en figure 4, les transistors M1 et M4 sont passants en même temps, et bloqués en même temps. Les transistors M2 et M3 sont également passants en même temps, et bloqués en même temps.

Dans le mode de réalisation décrit, le récepteur radiofréquence comportant le mixeur 100 est un récepteur de type NZIF. La fréquence $F_{RF}$ du signal radiofréquence S' est égale par exemple à 2,4 GHz + $F_{IF}$, où $F_{IF}$ est la fréquence du signal d'intérêt , la fréquence $F_{LO}$ du signal d'oscillation LO est par exemple égale à 2,4 GHz. L'invention peut également être mise en oeuvre dans un récepteur de type ZIF, dans lequel les fréquences $F_{LO}$ et $F_{RF}$ sont égales.

De manière générale, l'invention est mise en oeuvre pour des fréquences $F_{RF}$ et $F_{LO}$ telles que le ratio

$$\frac{F_{RF}}{F_{LO}}$$

est compris entre 0,5 et 2, en valeur absolue (0,5 et 2 étant non indus),

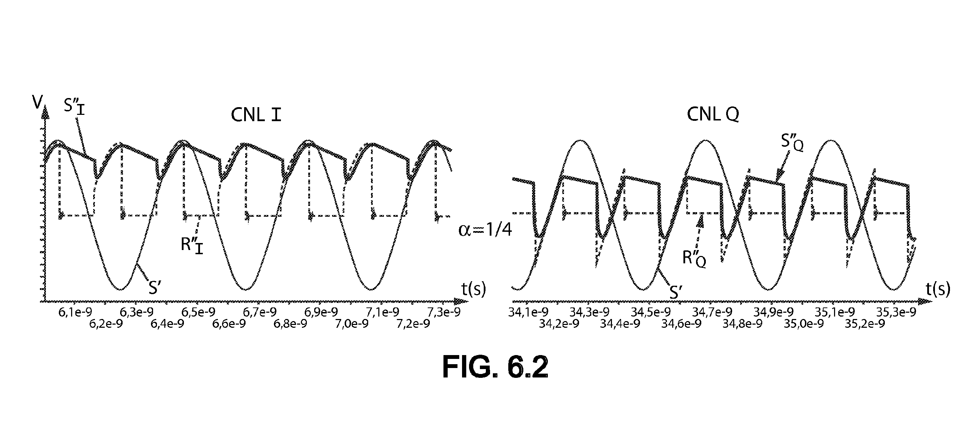

La figure 6.1 représente pour la voie I (partie gauche de la figure 6.1) l'évolution dans une fenêtre temporelle de la tension du signal S' (trait fin) fourni en entrée du mixeur 100, du signal $\overset{''}{S_I}$ (trait épais) qui est le signal de sortie lorsque la valeur de la capacité C1 du condensateur 109 est faible et du signal théorique $\overset{''}{R_I}$ (trait pointillé) qui est le signal de sortie lorsque la valeur de la capacité C1 des condensateurs 109 est nulle dans un schéma théorique.

La figure 6.1 représente pour la voie Q (partie droite de la figure 6.1) l'évolution dans la fenêtre temporelle de la tension du signal S' (trait fin) fourni en entrée du mixeur 100, du signal $\overset{''}{S_Q}$ (trait épais) qui est le signal de sortie lorsque la valeur de la capacité C1 du condensateur 110 est faible et du signal théorique $\overset{''}{R_Q}$ (trait pointillé) qui est le signal de sortie lorsque la valeur de la capacité C1 du condensateur 110 est nulle dans un schéma théorique.

En référence à la figure 5.1 et à la partie relative à la voie I, située à gauche de la figure 6.1 pendant une première phase $\tau 1M$ de durée $\tau$, le signal LOIM est à l'état haut, le signal LOIP est à l'état bas. Les transistors M1 et M4 sont passants tandis que les transistors M2 et M3 sont bloqués. Le signal $\overset{''}{S_I}$ fourni pendant la phase $\tau 1M$ par le module de mélange 102 (cas où C1 $\neq$ 0) ou le signal $\overset{''}{R_I}$ fourni pendant la phase $\tau 1$ par le module de mélange 102 (cas où C1 = 0) est alors égal à -S'.

Des phases $\tau 2M$, $\tau 3M$ etc. similaires à cette phase $\tau 1M$ ont lieu toutes les périodes de durée T.

Puis pendant une phase t1, les signaux LOIM et LOIP sont tous deux à l'état bas. Les transistors M1, M2, M3 et M4 sont bloqués. Le signal $\overset{''}{R_I}$ fourni pendant la phase t1 par le module de mélange 102 (cas où C1 = 0) est alors égal à 0. Le signal $\overset{''}{S_I}$ fourni pendant la phase t1 par le module de mélange 102 (cas où C1 $\neq$ 0) est alors égal à la tension délivrée aux bornes du condensateur 109 qui se décharge au travers de l'impédance de charge $Z_{PMA}$ de l'amplificateur post mixeur 14, réalisant ainsi sur la phase t1 un moyennage des valeurs prises par la tension -S' pendant la phase $\tau 1M$, jusqu'à ce qu'une paire de transistors redeviennent passants. La moyenne du signal $\overset{''}{S_I}$ délivré pendant la phase t1 est finalement égale à la moyenne du signal S' sur une fraction de temps correspondant à la phase $\tau 1M$ car dans ce mode de réalisation, la décharge de la capacité dans l'impédance $Z_{PMA}$ est négligeable.

Des phases t3, t5, etc. similaires à cette phase t1 ont lieu toutes les périodes de durée T.

Ensuite, pendant une première phase $\tau 1P$ de durée $\tau$, le signal LOIP est à l'état haut, le signal LOIM est à l'état bas. Les transistors M2 et M3 sont passants tandis que les transistors M1 et M4 sont bloqués. Le signal $\overset{''}{S_I}$ fourni pendant la phase $\tau 1P$ par le module de mélange 102 (cas où C1 $\neq$ 0), ou le signal ou le signal $\overset{''}{R_I}$ fourni pendant la phase $\tau 1P$ par le module de mélange 102 (cas où C1 = 0) est alors égal à S'.

Des phases $\tau 2P$, $\tau 3P$ etc. similaires à cette phase $\tau 1P$ ont lieu toutes les périodes de durée T.

Puis pendant une phase t2 (telle que T = 2$\tau$ + t1 + t2), les signaux LOIM et LOIP sont tous deux à l'état bas. Les transistors M1, M2, M3 et M4 sont bloqués. Le

signal $\overset{"}{R_i}$ fourni pendant la phase t2 par le module de mélange 102 (cas où C1 = 0) est alors égal à 0. Le signal

$\overset{"}{S_i}$ fourni pendant la phase t2 par le module de mélange 102 (cas où C1 ≠ 0) est alors égal à la tension délivrée aux bornes du condensateur 109 qui se décharge à nouveau dans l'impédance $Z_{PMA}$, réalisant ainsi, sur la phase t2, un moyennage des valeurs prises par la tension

S' pendant la phase τ1*P*. La moyenne du signal $\overset{"}{S_i}$ délivré pendant la phase t2 est finalement égale à la moyenne du signal S' sur la phase τ1*P* car dans ce mode de réalisation, la décharge de la capacité dans l'impédance $Z_{PMA}$ est négligeable.

Des phases t4, t6, etc. similaires à cette phase t2 ont lieu toutes les périodes de durée T. Le fonctionnement du module de mélange 103 de la voie Q est similaire au module de mélange 102 de la voie I, si ce n'est que les signaux LOI et LOQ sont déphasés de 90°.

Les courbes commentées ci-dessus correspondent à une valeur de la capacité C1 des condensateurs 109, 110 nulle ou faible. En pratique, la valeur de la capacité C1 est choisie de manière à être suffisante pour filtrer notamment les harmoniques d'ordre 2 du signal délivré en sortie du module de mélange 102. Sur la partie gauche de la figure, 6.1 est représentée l'évolution dans une fenêtre temporelle de la tension du signal $T_I$ (représenté selon une alternance de traits longs et traits courts) qui est le signal de sortie de la vole I lorsque la valeur de la capacité C1 est choisie de manière à être suffisante pour filtrer notamment les harmoniques d'ordre 2. Ce signai $T_I$ apparaît sensiblement rectiligne sur la durée considérée. Son amplitude est sensiblement égale à la valeur moyenne du signal S' sur la phase τ1*M*.

Sur la partie droite de la figure 6.1 est représentée l'évolution dans une fenêtre temporelle de la tension du signal $T_Q$ (représenté selon une alternance de traits longs et traits courts) qui est le signal de sortie de la voie Q lorsque la valeur de la capacité C1 est choisie de manière à être suffisante pour filtrer notamment les harmoniques d'ordre 2. Ce signal $T_Q$ apparaît sensiblement rectiligne sur la durée considérée. Son amplitude est sensiblement égale à la valeur moyenne du signal S' sur une phase où une paire de transistors est passante.

La figure 6.1 représente les variations de la tension des signaux délivrés par le mixeur 100 sur les voies I et Q lorsque le rapport de cycle α des signaux d'oscillation LOIM, LOIP, LOQM, LOQP est égal à 0,1. La figure 6.2 représente les variations des signaux délivrés par le mixeur 100 lorsque le rapport de cycle α des signaux d'oscillation LOIM, LOIP, LOQM, LOQP est égal à 0,25. Les durées pendant lesquelles les transistors sont passants est plus grande sur la figure 6.2.

Plus la valeur du rapport de cycle α est faible, plus la valeur moyenne du signal $\overset{"}{S_i}$ ou $\overset{"}{S_Q}$ délivré en sortie est proche de la valeur maximum du signal S'.

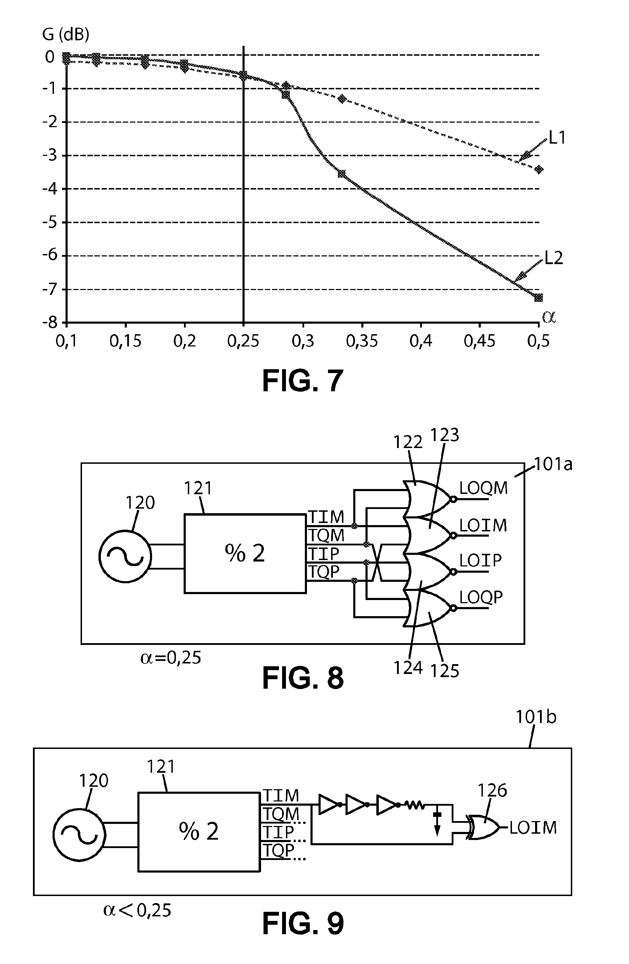

Le gain en tension d'un mixeur 100 est représenté sur la figure 7 en fonction du rapport cyclique α théorique (temps de montée et de descente des fronts des signaux d'oscillation considérés nuls) des signaux d'oscillation dans deux cas correspondant respectivement aux courbes L1 et L2.

Dans la réalité, le rapport cyclique α est calculé en considérant dans le temps à l'état haut une partie des phases de montée et de descente des fronts des signaux d'oscillation (en fonction de la valeur du mode commun, c'est-à-dire en fonction de la tension de polarisation des transistors correspondant à la commutation), et correspond donc à un rapport cyclique effectif plus faible, donc à un gain supérieur.

La courbe L1 correspond au cas où l'étage du module LNA 2 représenté sur la figure 1 en amont du mixeur 100 présente deux modules distincts de sortie du LNA délivrant la tension S', l'un à l'entrée du module de mélange 102 de la voie I, l'autre à l'entrée du module de mélange 103 de la voie Q, de façon non connectée en sortie desdits modules.

La courbe L2 correspond au cas où l'étage du module LNA en amont du mixeur 100 présente un module de sortie du LNA qui délivre de façon commune la tension S' aux modules de mélange 102, 103 des voies I et Q, tel que le module 120 représenté sur la figure 4, comportant une source de courant $I_{LNA}$ et une impédance R1. Les voies I et Q sont alors connectés en sortie du LNA 2.

Un module de sortie du LNA, par exemple un circuit tampon ou butter, est adapté pour délivrer en sortie une tension recopiant, voire amplifiant la tension qu'il reçoit en entrée, tout en présentant en sortie, au mixeur 100, une impédance plus faible que l'impédance $Z_{PMA}$ en sortie du mixeur, présentée par l'amplificateur PMA 14. Un LNA peut comporter un tel circuit par voie ou commun aux deux voies, ou une cascade de tels modules.

Pour chacune des courbes L1, L2, plus le rapport cyclique, strictement inférieur à 0,5, est faible, plus le gain du mixeur 100 est accru. L'accroissement du gain est plus particulièrement sensible lorsque le rapport cyclique a est inférieur à 0,25. Dans un tel cas, il n'existe pas de zone temporelle pendant laquelle les signaux d'oscillations LOIP et LOQP sont tous deux à l'état haut. De même, les Signaux d'oscillations LOIM et LOQM ne sont jamais à l'état haut en même temps.

En effet, pour la courbe L1, le gain est de -3,8 dB environ pour α=0,5, de -0,9 dB pour α=0,25 et augmente progressivement lorsque α diminue, jusqu'à atteindre -0,1 dB pour α=0,1 .

Pour la courbe L2, le gain est de -7,4 dB environ pour α=0,5, de -0,9 dB pour α=0,25 et augmente progressivement lorsque α diminue, jusqu'à atteindre -0,1 dB pour α=0,1.

Comme on le voit en comparant les courbes L1 et L2, la mise en oeuvre de l'invention dans un mixeur permet de s'affranchir de la contrainte d'utiliser deux modules séparés en sortie du LNA déconnectant la voie 1 de la voie Q lorsque le rapport de cycle est inférieure à 0,25. En effet, dans l'art antérieur, l'utilisation de deux modules de sortie du LNA séparés était avantageuse car elle évitait une dégradation supplémentaire du gain due à une décharge d'une des voies I, Q dans l'autre voie lorsque les voies I et Q étaient passantes en même temps.

Lorsque le rapport de cycle est inférieur à 0,25 comme décrit dans l'invention, il n'y a plus de moment où les voies I et Q sont simultanément passantes. Il n'y a donc plus parasitage d'une voie par l'autre. Utiliser un module de sortie du LNA commun aux voies I et Q permet même d'accroître le gain lorsque la valeur du rapport de cycle est inférieure à 0,25 par rapport à deux modules séparés. On gagne également en encombrement sur le circuit intégré du système sur puce.

En fait, le cas où la valeur de la capacité du condensateur 109 ou 110 est nulle considérée en référence aux figures 6.1 et 6.2 est un cas purement théorique, car les transistors M1, M2, M3 et M4 présentent toujours une capacitance parasite non nulle.

Les signaux $S_I''$ et $S_Q''$ indiquant le résultat des multiplications effectuées par les modules de mélanges 102, 103 des voies I et Q sont délivrés ensuite à l'amplificateur PMA 14 tel que représenté en figure 1, qui va extraire la composante d'intérêt pour la soumettre à des traitements dans le récepteur radiofréquence (par exemple, une conversion analogique-numérique).

L'impédance de charge $Z_{PMA}$ doit être de valeur suffisamment grande pour ne pas décharger les condensateurs 109, 110 lorsqu'une paire de transistors (M1, M4) ou (M2, M3) est passante.

Par ailleurs, chaque condensateur 109, 110 supprime les fréquences hautes en sortie du mixer 100, notamment les composantes à +/- ($F_{RF} + F_{LO}$). Plus le rapport de cycle a diminue, plus la fréquence de coupure Fc du filtre réalisé par le condensateur 109, 110, au-delà de laquelle les fréquences sont supprimées, diminue. En effet, lorsqu'une paire de transistors (M1, M4) ou (M2, M3) sont passants, le couple R1.C1 définit le filtrage. En revanche, lorsque tous les transistors sont bloqués, la résistance R1 vue du condensateur devient infinie. Donc la valeur moyenne de R1 vue par le condensateur 109, 110 est $\dfrac{R1}{2\alpha}$. La fréquence de coupure Fc est donc égale à $\dfrac{2\alpha}{2\pi R1 \times C1}$.

Cette disposition permet donc de disposer d'une fréquence de coupure diminuée, tout en conservant la composante située à +/- $F_{IF}$.

Réduire la valeur du rapport de cycle permet également à fréquence de coupure constante de gagner de la place sur le circuit intégré : en diminuant le rapport de cycle d'un facteur 2, on diminue d'un facteur 2 la taille des condensateurs 109,110.

Dans un mode de réalisation de l'invention, on constitue un générateur 101a de signaux d'oscillation sensiblement carrés LOIM, LOIP, LOQM, LOQP de fréquence $F_{LO}$ et présentant un rapport de cycle $\alpha$=0,25 en mettant en série, en référence à la figure 8 un générateur 120 de signaux carrés de fréquence $2F_{LO}$ suivi un diviseur de fréquence par 2 qui délivre des signaux TIM, TQM, TIP, TQP sensiblement carrés, de fréquence $F_{LO}$ similaires aux signaux représentés sur les figures 2.1 et 2.2. Puis on connecte en entrée d'une porte logique 122 NON OU (en anglais « NOR ») les signaux TIM et TQM pour obtenir LOQM. On connecte en entrée d'une porte logique 123 NON OU les signaux TIM et TQP pour obtenir LOIM. On connecte en entrée d'une porte logique 124 NON OU les signaux TIP et TQM pour obtenir LOIP. Enfin on connecte en entrée d'une porte logique 125 NON OU les signaux TIP et TQP pour obtenir LOQP.

Dans d'autres modes de réalisation, des portes logiques NON ET (« NAND » en anglais) et des inverseurs sont utilisées à la place des portes NON OU.

Dans un mode de réalisation de l'invention, en vue de constituer un générateur 101b de signaux d'oscillation sensiblement carrés LOIM, LOIP, LOQM, LOQP, de fréquence $F_{LO}$ et présentant un rapport de cycle $\alpha$ strictement inférieur à 0,25, en référence à la figure 9, on dispose en série, en référence à la figure 8 un générateur 120 de signaux carrés de fréquence $2F_{LO}$ suivi un diviseur de fréquence par 2 qui délivre des signaux TIM, TIP en quadrature avec des signaux TQM, TQP, tous ces signaux étant sensiblement carrés, de fréquence $F_{LO}$ et similaires aux signaux représentés sur les figures 2.1 et 2.2. Puis pour constituer le signal d'oscillation LOIM, on connecte en entrée d'une porte OU EXCLUSIF (« XOR » en anglais) d'une part le signal TIM, d'autre part un signal égal au signal TIM retardé (à l'aide d'un inverseur et/ou de circuits RC). Dans un autre mode de réalisation, on remplace les portes XOR par des portes NOR ou NAND.

L'invention a été considérée ci-dessus dans une application à un mélangeur tension-tension, qui signifie que la source d'entrée (le dernier étage de l'amplificateur faible bruit) est relativement basse impédance par rapport à la charge de sortie $Z_{PMA}$.

Par ailleurs, l'invention a ci-dessus été implémentée dans un mélangeur à réjection d'image. Elle peut être également implémentée dans un mélangeur sans réjection d'image, ne comportant donc pas de voie Q.

L'invention a été décrite ci-dessus avec un signal d'oscillation LOI, LOQ différentiel et un signal d'entrée S' différentiel. Elle peut bien sûr être implémentée dans un mixeur adapté pour multiplier un signal reçu en entrée par un signal d'oscillation non différentiel, dit simple (en anglais « single »), le signal d'entrée étant lui-même différentiel ou simple.

L'invention a été décrite ci-dessus en utilisant une technologie CMOS. Elle peut bien sûr être implémentée dans des circuits intégrés comportant des composants basés sur d'autres technologies, par exemple AsGa, BiCmos, etc.

**Revendications**

1. Mixeur radiofréquence (100) comportant

   - une borne (B) sur laquelle, en fonctionnement, un premier signal radiofréquence (LOI) est disponible;
   - une entrée (I1, I2) pour recevoir un second signal radiofréquence (S') ;
   - des moyens de multiplication (103, 102) adaptés pour multiplier le premier signal radiofréquence au second signal radiofréquence

   **caractérisé en ce que** le premier signal radiofréquence est

   - soit un signal différentiel, correspondant à la différence entre une première composante de signal (LOIP) et une seconde composante de signal (LOIM) correspondant chacune à un signal respectif sensiblement carré et de rapport cyclique ($\alpha$) inférieur à 0,25;
   - soit un signal simple qui est un signal non différentiel sensiblement carré dont le rapport cyclique est inférieur à 0,25.

2. Mixeur (100) selon l'une des revendications précédentes, comprenant une sortie (O1I, O2I) pour délivrer une tension $\left( S_j'' \right)$ indiquant le résultat de la multiplication du premier signal radiofréquence (LOI) et du second signal radiofréquence (S'), et comprenant un condensateur (109) en parallèle sur ladite sortie.

3. Mixeur selon l'une des revendications précédentes, dans lequel le premier signal radiofréquence (LOI) a une première fréquence ($F_{LO}$) et le second signal radiofréquence (S') a une seconde fréquence ($F_{RF}$), et dans lequel la valeur absolue du quotient de la seconde fréquence par la première fréquence est comprise entre 0,5 et 2, 0,5 et 2 non inclus.

4. Mixeur (100) selon l'une des revendications précédentes, dans lequel le premier signal (LOI) est un signal différentiel et dans lequel les moyens de multiplication (102) comportent deux bornes d'entrée différentielles (I1, I2) et deux bornes de sortie différentielles (O1I, O2I), et dans lequel, en outre :

   - la première borne d'entrée est couplée aux sources communes d'un premier (M1) et deuxième transistors (M2), la seconde borne d'entrée est couplée aux sources communes d'un troisième (M3) et quatrième (M4) transistors ;
   - les grilles communes des premier (M1) et quatrième (M4) transistors reçoivent la première composante de signal (LOIM) et les grilles communes des deuxième (M2) et troisième (M3) transistors reçoivent la seconde composante de signal (LOIP) ;
   - la première borne de sortie (O1I) est couplée aux drains communs des premier (M1) et troisième (M3) transistors, la seconde borne de sortie (O2I) est couplée aux drains communs des deuxième (M2) et quatrième (M4) transistors.

5. Système sur puce comprenant au moins un mixeur (100) selon l'une quelconque des revendications précédentes.

6. Téléphone mobile comprenant au moins un système sur puce selon la revendication 5.

7. Procédé de traitement de signaux dans un mixeur (100) adapté pour multiplier un premier signal radiofréquence (LOI) à un second signai radiofréquence (S'),
   ledit procédé étant **caractérisé en ce que** le premier signal radiofréquence est :

   - soit un signal différentiel, correspondant à la différence entre une première composante de signal (LOIP) et une seconde composante de signal (LOIM) correspondant chacune à un signal respectif sensiblement carré et de rapport cyclique ($\alpha$) inférieur à 0,25;
   - soit un signal simple qui est un signal non différentiel sensiblement carré dont le rapport cyclique est inférieur à 0,25.

8. Procédé selon la revendication 7, selon lequel le premier signal radiofréquence (LOI) a une première fréquence ($F_{LO}$) et le second signal radiofréquence (S') a une seconde fréquence ($F_{RF}$), et la valeur absolue du quotient de la seconde fréquence par la première fréquence est comprise entre 0,5 et 2, 0,5 et 2 non inclus.

9. Procédé selon l'une des revendications 7 et 8, le mixeur (100) comportant une sortie (O1I, O2I) pour délivrer une tension $\left( S_j'' \right)$ indiquant le résultat de la multiplication des premier et second signaux radiofréquences, selon lequel on dispose en outre un condensateur (109) en parallèle sur ladite sortie.

# FIG. 1
(ART ANTÉRIEUR)

# FIG. 4

# FIG. 3.1
(ART ANTÉRIEUR)

CNL I

# FIG. 3.2
(ART ANTÉRIEUR)

CNL Q

# FIG. 2.1
(ART ANTÉRIEUR)

# FIG. 2.2
(ART ANTÉRIEUR)

EP 1 926 208 A1

FIG. 5.1

FIG. 5.2

FIG. 6.1

FIG. 6.2

EP 1 926 208 A1

**FIG. 7**

$\alpha = 0,25$

**FIG. 8**

$\alpha < 0,25$

**FIG. 9**

Office européen
des brevets

**RAPPORT DE RECHERCHE EUROPEENNE**

Numéro de la demande

EP 07 12 1173

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 711 397 B1 (PETROV ANDREI R [US] ET AL) 23 mars 2004 (2004-03-23) | 1,3,5-8 | INV. H03D7/14 |
| Y | * colonne 5, ligne 58 - colonne 7, ligne 40; figures 2-4Dii * | 2,4,9 | |
| Y | US 2004/121751 A1 (SHEN DAVID H [US]) 24 juin 2004 (2004-06-24) * alinéas [0005], [0018]; figure 4 * | 2,4,9 | |
| X | EP 1 615 336 A (ERICSSON TELEFON AB L M [SE]) 11 janvier 2006 (2006-01-11) | 1,2,7,9 | |
| A | * alinéa [0053]; figures 2,5,6 * | 3-6,8 | |
| X | US 2005/215215 A1 (SHEMESH YAIR [IL] ET AL) 29 septembre 2005 (2005-09-29) | 1,7 | |
| A | * alinéa [0014] - alinéa [0028]; figures 1,2 * | 2-6,8,9 | |
| X | DE 10 2004 059117 A1 (ATMEL GERMANY GMBH [DE]) 29 juin 2006 (2006-06-29) | 1,7 | |
| A | * alinéa [0042] - alinéa [0043]; figures 5a,5b,6 * | 2-6,8,9 | DOMAINES TECHNIQUES RECHERCHES (IPC) |
| A | US 2003/162515 A1 (ZHOU SINING [US]) 28 août 2003 (2003-08-28) * alinéa [0046] - alinéa [0049]; figure 6 * | 1-9 | H03D H04B |

Le présent rapport a été établi pour toutes les revendications

| Lieu de la recherche | Date d'achèvement de la recherche | Examinateur |
|---|---|---|
| Munich | 31 mars 2008 | Ratajski, André |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 12 1173

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-03-2008

| Document brevet cité au rapport de recherche | | Date de publication | Membre(s) de la famille de brevet(s) | | Date de publication |
|---|---|---|---|---|---|
| US 6711397 | B1 | 23-03-2004 | AUCUN | | |
| US 2004121751 | A1 | 24-06-2004 | US | 2007243847 A1 | 18-10-2007 |
| EP 1615336 | A | 11-01-2006 | AT | 373338 T | 15-09-2007 |
| | | | CN | 101010872 A | 01-08-2007 |
| | | | US | 2007287403 A1 | 13-12-2007 |
| US 2005215215 | A1 | 29-09-2005 | AUCUN | | |
| DE 102004059117 | A1 | 29-06-2006 | EP | 1831989 A1 | 12-09-2007 |
| | | | WO | 2006061204 A1 | 15-06-2006 |
| | | | US | 2007264961 A1 | 15-11-2007 |
| US 2003162515 | A1 | 28-08-2003 | AUCUN | | |

EPO FORM P0460

Pour tout renseignement concernant cette annexe : voir Journal Officiel de l'Office européen des brevets, No.12/82